# EUROPEAN PATENT APPLICATION

(11) **EP 4 807 373 A1**
(43) Date of publication of application: **16.09.2026**
(21) Application number: 25225582.3
(22) Date of filing: 19.12.2025
(51) Int. Cl.: G01R 15/18

(54) **SYSTEMS AND METHODS FOR CONTACTLESS CURRENT SENSING USING PCB-INTEGRATED COIL FOR VEHICLE**

(30) Priority: 12.03.2025 US 202563770476 P; 16.12.2025 US 202519421096
(71) Applicant: Borgwarner Inc., Auburn Hills, Michigan 48326 (US)
(72) Inventor: WU, Xiangchun, South Lyon, MI (US); CUI, Junwei, Carmel, IN (US)
(74) Representative: Office Freylinger

(57) **Abstract**

A system includes a power converter, the power converter including: a first alternating current (AC) busbar; and a printed circuit board (PCB), the PCB including a first current sensor to sense a first current in the first AC busbar, wherein the first current sensor includes: a first coil in a first layer of the PCB, a second coil in the first layer of the PCB, the second coil connected to the first coil in a series electrical connection, and a first current signal conditioner connected to the first coil and the second coil.

## Description

### TECHNICAL FIELD

Various embodiments of the present disclosure relate generally to systems and methods for contactless current sensing and, more particularly, to systems and methods for contactless current sensing using PCB-integrated coils for vehicle power conversion systems.

### BACKGROUND

High power current sensor systems in electric vehicles and power conversion applications typically employ current conversion modules such as current transformers, Hall effect current sensors, or integrated current sensor ICs to measure electrical current flowing through busbars. These conventional approaches present several challenges including the requirement to reshape busbars to concentrate magnetic flux, which reduces the cross-sectional area and increases power losses and thermal issues, sensitivity to vibration and displacement that affects measurement accuracy, large physical size that complicates system packaging design, and the need for additional auxiliary components that increase system cost and complexity while potentially reducing overall reliability.

The present disclosure is directed to overcoming one or more of these above-referenced challenges.

### SUMMARY OF THE DISCLOSURE

In some aspects, the techniques described herein relate to a system including a power converter, the power converter including: a first alternating current (AC) busbar; and a printed circuit board (PCB), the PCB including a first current sensor to sense a first current in the first AC busbar, wherein the first current sensor includes: a first coil in a first layer of the PCB, a second coil in the first layer of the PCB, the second coil connected to the first coil in a series electrical connection, and a first current signal conditioner connected to the first coil and the second coil.

In some aspects, the techniques described herein relate to a system, wherein the first current sensor does not include a current converter in addition to the first coil and the second coil.

In some aspects, the techniques described herein relate to a system, wherein the first AC busbar does not include a modification to concentrate magnetic flux for the first current sensor.

In some aspects, the techniques described herein relate to a system, wherein the first current sensor further includes: a third coil in a second layer of the PCB, and a fourth coil in the second layer of the PCB, wherein the third coil and the fourth coil are connected to the first current signal conditioner.

In some aspects, the techniques described herein relate to a system, the power converter further including: a second AC busbar; and a third AC busbar.

In some aspects, the techniques described herein relate to a system, the PCB further including: a second current sensor to sense a second current in the second AC busbar; and a third current sensor to sense a third current in the third AC busbar, wherein each of the second current sensor and the third current sensor includes a first coil in the first layer of the PCB and a second coil in the first layer of the PCB.

In some aspects, the techniques described herein relate to a system, the PCB further including: a second current signal conditioner connected to the first coil of the second current sensor and the second coil of the second current sensor; and a third current signal conditioner connected to the first coil of the third current sensor and the second coil of the third current sensor.

In some aspects, the techniques described herein relate to a system, wherein the first coil and the second coil are arranged on an axis perpendicular to a direction of the first current in the first AC busbar.

In some aspects, the techniques described herein relate to a system, wherein: a center of the first coil is aligned with a first edge of the first AC busbar, and a center of the second coil is aligned with a second edge of the first AC busbar.

In some aspects, the techniques described herein relate to a system, further including: one or more controllers configured to control the power converter based on the first current.

In some aspects, the techniques described herein relate to a system, further including: a battery; and a motor connected to one or more of the battery or the power converter, wherein the battery, the motor, and the power converter are provided as a vehicle.

In some aspects, the techniques described herein relate to a current sensor including: a first coil in a first layer of a printed circuit board (PCB); and a second coil in the first layer of the PCB, wherein the current sensor is configured to sense a current.

In some aspects, the techniques described herein relate to a current sensor, further including: a current signal conditioner connected to the first coil and the second coil.

In some aspects, the techniques described herein relate to a current sensor, further including: one or more of a resistor or an inductor connected to the current signal conditioner between the current signal conditioner and the first coil.

In some aspects, the techniques described herein relate to a current sensor, further including: a third coil in a second layer of the PCB; and a fourth coil in the second layer of the PCB, wherein the third coil and the fourth coil are connected to the current signal conditioner.

In some aspects, the techniques described herein relate to a current sensor, wherein the current sensor is configured to sense the current in a busbar.

In some aspects, the techniques described herein relate to a printed circuit board (PCB) including: a first layer; a first current sensor to sense a first current; a second current sensor to sense a second current; and a third current sensor to sense a third current, wherein each of the first current sensor, the second current sensor, and the third current sensor includes a first coil in the first layer of the PCB and a second coil in the first layer of the PCB.

In some aspects, the techniques described herein relate to a PCB, further including: a second layer, wherein each of the first current sensor, the second current sensor, and the third current sensor further includes a third coil in the second layer of the PCB and a fourth coil in the second layer of the PCB.

In some aspects, the techniques described herein relate to a PCB, further including: a first current signal conditioner connected to the first current sensor; a second current signal conditioner connected to the second current sensor; and a third current signal conditioner connected to the third current sensor.

In some aspects, the techniques described herein relate to a PCB, wherein the first current signal conditioner, the second current signal conditioner, and the third current signal conditioner are in the first layer of the PCB.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a power converter, according to one or more embodiments.
FIG. 2 depicts an exemplary system infrastructure for a power converter, according to one or more embodiments.
FIG. 3 depicts an exemplary system infrastructure for a controller, according to one or more embodiments.
FIG. 4 depicts a block diagram of a current sensor with a current transformation module and signal conditioner, according to one or more embodiments.
FIG. 5 depicts a perspective view of a current sensing system with a busbar and PCB-integrated coils, according to one or more embodiments.
FIG. 6 depicts a top orthogonal view of the current sensing system showing coil arrangement on the PCB, according to one or more embodiments.
FIG. 7 depicts a top view of a current sensing system with two coils positioned relative to a busbar, according to one or more embodiments.
FIG. 8 depicts a top view of a current sensing system with coils arranged symmetrically relative to a busbar, according to one or more embodiments.
FIG. 9 depicts a top view of a current sensing system with circular coils arranged symmetrically relative to a busbar, according to one or more embodiments.
FIG. 10 depicts a flowchart for a method for determining coil parameters for a current sensor, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to systems and methods for contactless current sensing and, more particularly, to systems and methods for contactless current sensing using PCB-integrated coils for vehicle power conversion systems.

Inverters, such as those used to drive a motor in an electric vehicle, for example, are responsible for converting High Voltage Direct Current (HVDC) into Alternating Current (AC) to drive the motor. A three phase inverter may include a bridge with six power device switches (for example, power transistors such as IGBT or MOSFET) that are controlled by Pulse Width Modulation (PWM) signals generated by a controller. An inverter may include three half-H bridge switches to control the phase voltage, upper and lower gate drivers to control the switches, a PWM controller, and glue logic between the PWM controller and the gate drivers. The PWM controller may generate signals to define the intended states of the system. The gate drivers may send the signals from the PWM controller to the half-H bridge switches. The half-H bridge switches may drive the phase voltage. Six phase (or other phase) inverters, chargers, DC-DC converters, and/or multi-level inverters are not excluded from this concept and will follow similar principles. The present disclosure refers to an inverter as an example embodiment of a power converter. Power converters may include chargers, inverters, or DC-DC converters, for example.

Electric vehicles, energy storage systems, and backup generators, for example, convert electric power from one form to another. Additionally, an on-board charger for a vehicle, for example, may have a dual purpose. The on-board charger may be a bi-directional system that converts AC voltage to DC voltage in a charging mode (grid-to-battery) and DC voltage to AC voltage in a discharge or inverter mode (battery-to-grid). The charging mode may convert the grid AC into DC voltage to charge the vehicle high voltage (HV) battery, and the discharge or inverter mode may convert the HV battery DC voltage into AC voltage that may be supplied to a load of the grid line voltage, be supplied as a backup generator to power a house when the grid is down, or as an inverter to supply voltage to vehicle AC outlets, for example.

Typical current conversion modules may be composed of current conversion elements and auxiliary elements. Current conversion elements may be current transformers or Hall current sensors. The conditioning circuit may be configured by a user to accommodate one or more requirements of a particular application. Deficiencies associated with conventional approaches may include high-power and high-current measurements that use corresponding large-size current conversion elements. These large-size current conversion elements may require specific packaging requirements for the package design for high-power conversion systems and expands the system package size.

Further, the use of a current conversion element and its auxiliary components for high current measurements may increase the relevant cost of high power conversion systems. For example, the current conversion element may have its own thermal constraints. Using this element in the power conversion system may cause more thermal problems related to the element, and the design of the system thermal cooling system must be strengthened. This may further increase the system size and cost. Additionally, since current conversion elements and their auxiliary components are used, the reliability of the system may be reduced due to the current conversion elements. Further, when performing the high current measurement using an integrated current sensor IC, a special busbar must be made to accommodate the size limitations of the integrated current sensor IC. This may limit the high current measurement and cause heating problems for the busbar, resulting in heating problems for the high power conversion system.

Some solutions use several types of current transformers and modules. For example, they may include a current transformer, a Hall current sensor, or an integrated current sensor IC. These current transformers and modules may include several disadvantages based on the current sensor concept in use. For example, the current transformer may require a large volume in order to measure the current, making it inefficient for inverter design, as inverters generally require compact and small sized components. Hall-effect current sensors and integrated current sensor IC, which respond to magnetic fields, may require the busbar to be reshaped or modified in order to produce sufficient magnetic flux or flux concentrate for accurate sensing. Further, integrated current sensor IC may require additional PCBs or additional conditioner circuits for accurate readings.

Reshaping or modifying the busbars to accommodate a Hall-effect current sensor or an integrated current-sensor IC may involve adding a notch to a busbar or incorporating an S-shaped profile into the busbar. Altering the busbar's geometry may reduce its cross-sectional area, which may introduce additional thermal challenges and increase power loss. For example, during normal operations, the modified busbar may generate more heat, leading to elevated temperatures, particularly near the region where the Hall sensor or integrated current-sensor IC is installed. This may impose a thermal constraint.

Another potential issue is vibration. Once the IC current sensor is installed, vibration in the X, Y, or even Z direction may introduce significant measurement error and adversely affect accuracy. This may also represent a limitation of the current sensor concept.

One or more embodiments may include two functional modules. One functional module may include a current conversion module and one functional module may include a signal conditioning circuit. The current conversion module may provide the function to convert the current to be measured to signal, and the conditioning circuit may condition the signal to the suitable scale and format to be read for control or display.

One or more embodiments may implement a current conversion function by incorporating one or more coils into a current sensing PCB board, thereby creating a new architecture of a current conversion module. The new current conversion module architecture may address the limitations associated with the current conversion elements used in conventional designs. For example, integration of a current transformer into a PCB may omit the use of additional current conversion element and its auxiliary components, thereby simplifying and reducing the size of a high power conversion system.

Additionally, removing the current conversion elements may reduce heat generation and eliminate the thermal limitations associated with those components. As a result, cooling systems previously required for such elements may no longer be necessary, thereby enabling high-power conversion systems to achieve better thermal performance and simplifying the overall cooling system design. Because the system packaging, busbar layout, and overall footprint may be simplified, the total system manufacturing cost may also be reduced. Further, since the integrated PCB coils may be more robust than the current conversion elements they replace, their removal, along with a streamlined cooling design, may significantly improve the reliability of high-power systems.

One or more embodiments may provide a fully embedded current measurement architecture (e.g., a current sensor) that may enable current measurement without requiring resizing or reshaping the busbar. The fully embedded current measurement architecture may avoid the previously described problems caused by busbar reshaping. The fully embedded current measurement architecture may reduce power loss and increase thermal performance. As the current sensor may employ a fully embedded architecture, it may exhibit enhanced mechanical integrity and improved long-term operational durability.

One or more embodiments may provide a method to implement contactless, coreless, and high compact alternating current (AC) measurement architecture to implement low cost system design. The new current sensing technology architecture may have new features not available in conventional approaches and may have new advantages. For example, for high current power systems, accurate current measurement may be achieved without reshaping the current bus. In large current measurement devices, one or more embodiments may capture the information of the entire current, without needing to customize the current busbar and to adapt to the size of the current conversion element as in conventional approaches. Therefore, compared with conventional approaches, one or more embodiments may achieve more accurate large current measurement.

One or more embodiments may provide improved temperature rise distribution in high power systems by use of integrated coils in a printed circuit board (PCB). The integrated coils in the PCB may realize current conversion while reducing heat generating compared to that of traditional conversion elements. Further, the integrated coils in the PCB may improve the thermal features of power conversion, simplify high power conversion system package design, thereby providing a compact package design.

One or more embodiments may simplify a cooling system configuration associated with a current sensor by the use of integrated coils in PCB for current conversion. The integrated coils in the PCB may omit the traditional current conversion element and its auxiliary components, thereby simplifying the cooling system design and reducing the system package size and manufacturing cost.

One or more embodiments may enhance high power system reliability by fully integrating one or more sensing coils in a PCB. The fully embedded sensing coils may improve the temperature rise distribution of the system, thereby increasing the reliability of power system. Additionally, the fully embedded architecture of the electronic elements within the PCB may provide improved mechanical robustness and enhanced protection against environmental factors, thereby extending their operational lifespan and reliability.

One or more embodiments may employ one or more coils embedded in a PCB to sense the magnetic flux generated by the current in one or more busbars, then generate an output voltage signal based on the sensed magnetic flux. The voltage signal may be provided to a signal conditioning circuit. The output of the signal conditioning circuitry may be configured for use by a microcontroller. The PCB board may be installed above the one or more busbars. The center of each of the one or more coils may be located at an edge of a busbar. The coils may help to sense a magnetic flux, which may be generated by the one or more busbars when current flows through each of the one or more busbars. For example, two coils may help to sense the magnetic flux, and then may generate a voltage signal, and the voltage signal may output to the conditional circuit, and then may be sent to the microcontroller. The microcontroller may then determine an amount of current flowing through the one or more busbars based on the received conditional circuit output.

One or more embodiments may replace a Hall effect current sensor, or an integrated current sensor IC, with two coils. Normally, the current sensor IC may be installed in the middle of the busbar and may require reshaping the busbar. By replacing the Hall effect current sensor or an integrated current sensor IC, there may be no need to customize the busbar, and there may be no need to notch or drill a hole in the busbar. Centering the two coils on two sides of the busbar may simplify the manufacture of the busbar, thereby reducing the cost. Additionally, the coils are not subject to the thermal limitations associated with traditional sensors, thereby simplifying the system design and enhancing overall durability. In some instances, the coils may be located on top of the busbar, and may not surround the busbar. Two coils may be employed per busbar. For example, the coils may be installed and integrated in the PCB, and the PCB may be installed above the busbar. If the PCB has two layers, then the coils may be installed on the first layer and also on the second layer. Coils may be located on each layer of the PCB. For example, for one phase, there may be two coils, and it may also be possible to install another two coils on the second layer, or on the bottom layer of the PCB. The bottom layer of the PCB may still be located on above the busbar. Coils may be installed on the top (or first) layer, and also may be installed on the back layer of the PCB. The PCB may be formed as a single unit and positioned above the busbar. In some instances, there may be four coils, with two coils located on both layers. Two coils may output a higher voltage signal to be transmitted to the conditioning circuit. However, if a higher output voltage is required, an additional two coils may be added. The additional two coils may be located on the same layer of the PCB as the original two coils. The additional two coils may be located on a different layer of the PCB as the original two coils.

When current flows through the busbar, a magnetic flux may be generated around the busbar. A coil positioned on a first side of the busbar may sense magnetic flux coming out of the face, and a coil positioned on a second side may sense magnetic flux flowing into the face of the busbar. Both coils may be serially connected, and generate a voltage. The voltage may be provided to the current signal conditioning circuit.

The magnetic flux density may be induced from measured current I: *B* = $\frac{μI}{2 πd}$*,* where µ may be permeability and d may be distance from the busbar carrying current to coil. Φ may be determined by B: *Φ* = ∲ *Bds,* where ∲ *Bds* may be the integral of B in the area enclosed by the coil. Vsen may be found from Φ: ${V}_{sen} = N \frac{dΦ}{dt}$ *,* where N may be turns of coils. Vo may be determined by conditioning circuit and Vₛₑₙ: *Vₒ* = *G* × *Vₛₑₙ,* where G may be gain of current signal conditioning circuit.

One or more embodiments may determine an architectural design to implement a current measurement function. The procedure to complete the architecture design to implement current measurement function may include: determining the range of current to be measured based on hardware system requirements; estimating a feasible voltage sense (V*ₛₑₙ*) range corresponding to the range of current to be measured and conditioning circuit gain; estimating coil parameters, including coil number and size, and coil turns; calculating the voltage sense (V*ₛₑₙ*) based on the estimated coil parameters and current with the distances from current sensor PCB mounting; determining whether the calculated voltage sense is within the range as the estimated voltage sense range; if the calculated voltage sense is within the estimated voltage sense range, then the coil parameters may be determined for current sensor PCB design and mounting; if the calculated voltage sense is not within the estimated voltage sense range, then the coil parameters may be re-estimated. This may be an iterative design process that may adjust coil parameters until the calculated voltage sense falls within the desired range, thereby ensuring proper current sensing functionality.

One or more embodiments may employ a current sensor that does not require a modification to a busbar to concentrate magnetic flux. For example, traditional types of current sensor may need a notch located within the busbar or to reshape the busbar into an S-shaped profile. Therefore, the current sensor provided in the one or more embodiments may simplify system design and improve manufacturing cost. The current sensor provided in the one or more embodiments may be universally compatible with various systems and may improve the temperature rise and thermal environment of the system. The current sensor may include copper coils as a cost-effective material.

One or more embodiments may provide a system where coils embedded within the layers of a PCB sense magnetic flux generated by current flowing through a busbar. The coils may be arranged in pairs on opposite sides of the busbar and connected in series to generate a voltage signal proportional to the current being measured. This voltage signal may then be processed by a signal conditioning circuit to produce an output suitable for use by a controller or microcontroller. The system may eliminate the need to reshape or modify the busbar, as the coils can sense the magnetic field without requiring concentrated flux paths.

One or more embodiments may achieve accurate current measurement without requiring busbar modifications such as notches, holes, or S-shaped configurations that are typically needed for Hall effect sensors or integrated current sensor ICs. This may eliminate the thermal problems associated with reduced cross-sectional areas in reshaped busbars, which may cause increased power losses and elevated temperatures. PCB-integrated coils may be inherently more robust than discrete current conversion elements and may be less sensitive to vibration and displacement in X, Y, or Z directions, thereby improving measurement accuracy and system reliability.

One or more embodiments may provide substantial cost advantages by eliminating the need for separate current conversion elements and their associated auxiliary components such as power supplies and additional PCBs. The coils may be fabricated using standard copper traces within the PCB manufacturing process, making them highly cost-effective compared to commercial current sensors. The system may also enable more compact packaging designs by removing the space requirements for large current transformers or discrete sensor components, thereby reducing overall system size and simplifying thermal management requirements.

One or more embodiments may improve system reliability by removing potential failure points associated with discrete current conversion elements. The integrated coils may have fewer components that can fail compared to complex integrated circuits or mechanical current transformers. The elimination of busbar reshaping requirements may also improve the mechanical integrity of the current-carrying conductors and reduce manufacturing complexity. The contactless nature of the sensing method may provide galvanic isolation between the current path and the measurement circuit, enhancing safety and reducing electromagnetic interference.

One or more embodiments may provide flexibility in implementation by allowing multiple coils to be integrated into different layers of a multi-layer PCB. For example, a two-layer PCB may accommodate up to four coils per current sensor, with two coils on each layer, enabling increased sensitivity or redundancy as required by the application. The number of turns in each coil and the spacing between coils may be optimized during the design process to achieve the desired voltage output range for specific current measurement requirements. This scalability may make the sensor suitable for a wide range of applications from low-power to high-power current sensing in electric vehicle power conversion systems.

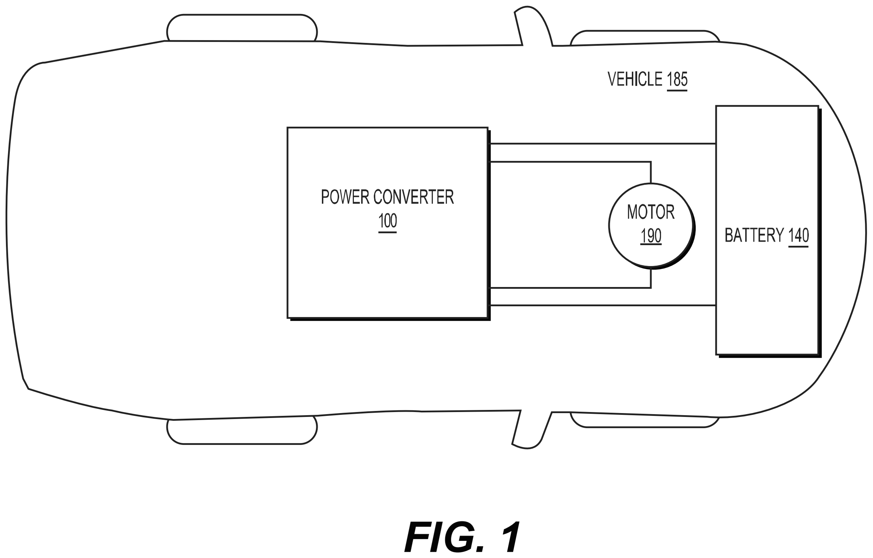

FIG. 1 depicts an exemplary system infrastructure for a vehicle including a power converter, according to one or more embodiments. The power converter 100 may be a combined inverter and converter. Alternatively, the inverter may be an inverter without a converter. In the context of this disclosure, a battery charger, the inverter, the converter, or any combination thereof may be referred to as power converter 100. Electric vehicle 185 may include power converter 100, motor 190, and battery 140. Power converter 100 may include components to receive electrical power from an external source and output electrical power to charge battery 140 of electric vehicle 185. Power converter 100 may convert DC power from battery 140 in electric vehicle 185 to AC power, to drive motor 190 of the electric vehicle 185, for example, but the embodiments are not limited thereto. For example, power converter 100 may include components to receive electrical power from an external source and output electrical power to charge battery 140 without motor 190 connected to power converter 100. Power converter 100 may convert DC power from battery 140 in electric vehicle 185 to AC power, to drive AC components other than motor 190 of the electric vehicle 185. Power converter 100 may be bidirectional, and may convert DC power to AC power, or convert AC power to DC power, such as during regenerative braking, for example. Power converter 100 may be a three-phase inverter, a single-phase inverter, or a multi-phase inverter.

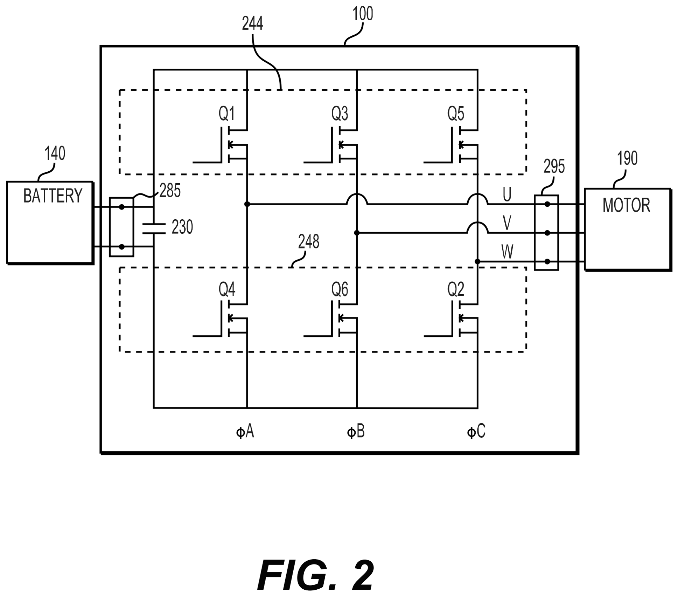

FIG. 2 depicts an exemplary system infrastructure for a power converter, according to one or more embodiments. Power converter 100 may be used to convert DC power from a battery in electric vehicle 185 to AC power, to drive motor 190 of electric vehicle 185, for example, but embodiments are not limited thereto. Additionally, power converter 100 may be bidirectional, and used to convert DC power to AC power, or to convert AC power to DC power.

Power converter 100 may be connected to battery 140 and motor 190. Power converter 100 may include upper phase switches 244 and lower phase switches 248. A first phase (ΦA) may include switches Q1 and Q4, a second phase (ΦB) may include switches Q3 and Q6, and a third phase (ΦC) may include switches Q5 and Q2. Upper phase switches 244 may include first phase switch Q1, second phase switch Q3, and third phase switch Q5. Lower phase switches 248 may include first phase switch Q4, second phase switch Q6, and third phase switch Q2. Switches Q1-Q6 may be metal-oxide-semiconductor field-effect transistors (MOSFET), for example, but embodiments are not limited thereto.

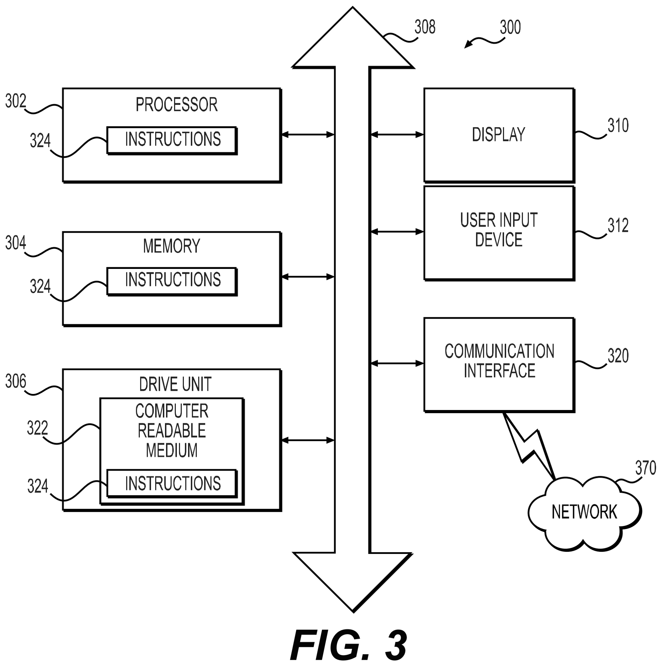

Upper phase switches 244 and lower phase switches 248 may be driven by a pulse width modulated (PWM) signal generated by controller 300 (e.g., see FIG. 3) to convert DC power delivered via the set of input terminals 285 at bulk capacitor 230 to three phase AC power at outputs U, V, and W (correlating with phases A, B, and C, respectively) via the set of output terminals 295 to motor 190. Additionally, although FIG. 2 depicts a three-phase inverter, the disclosure is not limited thereto and may include single phase or multi-phase or multi-level inverters.

FIG. 3 depicts an exemplary system infrastructure for a controller, according to one or more embodiments. Controller 300 may include one or more controllers.

The controller 300 may include a set of instructions that can be executed to cause the controller 300 to perform any one or more of the methods or computer-based functions disclosed herein. The controller 300 may operate as a standalone device or may be connected, e.g., using a network, to other computer systems or peripheral devices.

In a networked deployment, the controller 300 may operate in the capacity of a server or as a client in a server-client user network environment, or as a peer-to-computer system in a peer-to-peer (or distributed) network environment. The controller 300 can also be implemented as or incorporated into various devices, such as a power converter, a personal computer (PC), a tablet PC, a set-top box (STB), a personal digital assistant (PDA), a mobile device, a palmtop computer, a laptop computer, a desktop computer, a communications device, a wireless telephone, a land-line telephone, a control system, a camera, a scanner, a facsimile machine, a printer, a pager, a personal trusted device, a web appliance, a network router, switch or bridge, or any other machine capable of executing a set of instructions (sequential or otherwise) that specify actions to be taken by that machine. In a particular implementation, the controller 300 can be implemented using electronic devices that provide voice, video, or data communication. Further, while the controller 300 is illustrated as a single system, the term "system" shall also be taken to include any collection of systems or sub-systems that individually or jointly execute a set, or multiple sets, of instructions to perform one or more computer functions.

As depicted in FIG. 3, the controller 300 may include a processor 302, e.g., a central processing unit (CPU), a graphics processing unit (GPU), or both. The processor 302 may be a component in a variety of systems. The processor 302 may be one or more general processors, digital signal processors, application specific integrated circuits, field programmable gate arrays, servers, networks, digital circuits, analog circuits, combinations thereof, or other now known or later developed devices for analyzing and processing data. The processor 302 may implement a software program, such as code generated manually (i.e., programmed).

The controller 300 may include a memory 304 that can communicate via a bus 308. The memory 304 may be a main memory, a static memory, or a dynamic memory. The memory 304 may include, but is not limited to computer readable storage media such as various types of volatile and non-volatile storage media, including but not limited to random access memory, read-only memory, programmable read-only memory, electrically programmable read-only memory, electrically erasable read-only memory, flash memory, magnetic tape or disk, optical media and the like. In one implementation, the memory 304 includes a cache or random-access memory for the processor 302. In alternative implementations, the memory 304 is separate from the processor 302, such as a cache memory of a processor, the system memory, or other memory. The memory 304 may be an external storage device or database for storing data. Examples include a hard drive, compact disc ("CD"), digital video disc ("DVD"), memory card, memory stick, floppy disc, universal serial bus ("USB") memory device, or any other device operative to store data. The memory 304 is operable to store instructions executable by the processor 302. The functions, acts or tasks illustrated in the figures or described herein may be performed by the processor 302 executing the instructions stored in the memory 304. The functions, acts or tasks are independent of the particular type of instructions set, storage media, processor or processing strategy and may be performed by software, hardware, integrated circuits, firmware, micro-code, and the like, operating alone or in combination. Likewise, processing strategies may include multiprocessing, multitasking, parallel processing, and the like.

As depicted, the controller 300 may further include a display 310, such as a liquid crystal display (LCD), an organic light emitting diode (OLED), a flat panel display, a solid-state display, a cathode ray tube (CRT), a projector, a printer or other now known or later developed display device for outputting determined information. The display 310 may act as an interface for the user to see the functioning of the processor 302, or specifically as an interface with the software stored in the memory 304 or in the drive unit 306.

Additionally or alternatively, the controller 300 may include an input device 312 configured to allow a user to interact with any of the components of controller 300. The input device 312 may be a number pad, a keyboard, or a cursor control device, such as a mouse, or a joystick, touch screen display, remote control, or any other device operative to interact with the controller 300.

The controller 300 may also or alternatively include drive unit 306 implemented as a disk or optical drive. The drive unit 306 may include a computer-readable medium 322 in which one or more sets of instructions 324, e.g., software, can be embedded. Further, the instructions 324 may embody one or more of the methods or logic as described herein. The instructions 324 may reside completely or partially within the memory 304 and/or within the processor 302 during execution by the controller 300. The memory 304 and the processor 302 also may include computer-readable media as discussed above.

In some systems, a computer-readable medium 322 includes instructions 324 or receives and executes instructions 324 responsive to a propagated signal so that a device connected to a network 370 can communicate voice, video, audio, images, or any other data over the network 370. Further, the instructions 324 may be transmitted or received over the network 370 via a communication port or interface 320, and/or using a bus 308. The communication port or interface 320 may be a part of the processor 302 or may be a separate component. The communication port or interface 320 may be created in software or may be a physical connection in hardware. The communication port or interface 320 may be configured to connect with a network 370, external media, the display 310, or any other components in controller 300, or combinations thereof. The connection with the network 370 may be a physical connection, such as a wired Ethernet connection or may be established wirelessly as discussed below. Likewise, the additional connections with other components of the controller 300 may be physical connections or may be established wirelessly. The network 370 may alternatively be directly connected to a bus 308.

While the computer-readable medium 322 is depicted to be a single medium, the term "computer-readable medium" may include a single medium or multiple media, such as a centralized or distributed database, and/or associated caches and servers that store one or more sets of instructions. The term "computer-readable medium" may also include any medium that is capable of storing, encoding, or carrying a set of instructions for execution by a processor or that causes a computer system to perform any one or more of the methods or operations disclosed herein. The computer-readable medium 322 may be non-transitory and may be tangible.

The computer-readable medium 322 can include a solid-state memory such as a memory card or other package that houses one or more non-volatile read-only memories. The computer-readable medium 322 can be a random-access memory or other volatile re-writable memory. Additionally or alternatively, the computer-readable medium 322 can include a magneto-optical or optical medium, such as a disk or tapes or other storage device to capture carrier wave signals such as a signal communicated over a transmission medium. A digital file attachment to an e-mail or other self-contained information archive or set of archives may be considered a distribution medium that is a tangible storage medium. Accordingly, the disclosure is considered to include any one or more of a computer-readable medium or a distribution medium and other equivalents and successor media, in which data or instructions may be stored.

In an alternative implementation, dedicated hardware implementations, such as application specific integrated circuits, programmable logic arrays and other hardware devices, can be constructed to implement one or more of the methods described herein. Applications that may include the apparatus and systems of various implementations can broadly include a variety of electronic and computer systems. One or more implementations described herein may implement functions using two or more specific interconnected hardware modules or devices with related control and data signals that can be communicated between and through the modules, or as portions of an application-specific integrated circuit. Accordingly, the present system encompasses software, firmware, and hardware implementations.

The controller 300 may be connected to a network 370. The network 370 may define one or more networks including wired or wireless networks. The wireless network may be a cellular telephone network, an 802.11, 802.16, 802.20, or WiMAX network. Further, such networks may include a public network, such as the Internet, a private network, such as an intranet, or combinations thereof, and may utilize a variety of networking protocols now available or later developed including but not limited to TCP/IP based networking protocols. The network 370 may include wide area networks (WAN), such as the Internet, local area networks (LAN), campus area networks, metropolitan area networks, a direct connection such as through a Universal Serial Bus (USB) port, or any other networks that may allow for data communication. The network 370 may be configured to couple one computing device to another computing device to enable communication of data between the devices. The network 370 may generally be enabled to employ any form of machine-readable media for communicating information from one device to another. The network 370 may include communication methods by which information may travel between computing devices. The network 370 may be divided into sub-networks. The sub-networks may allow access to all of the other components connected thereto or the sub-networks may restrict access between the components. The network 370 may be regarded as a public or private network connection and may include, for example, a virtual private network or an encryption or other security mechanism employed over the public Internet, or the like.

In accordance with various implementations of the present disclosure, the methods described herein may be implemented by software programs executable by a computer system. Further, in an exemplary, non-limited implementation, implementations can include distributed processing, component or object distributed processing, and parallel processing. Alternatively, virtual computer system processing can be constructed to implement one or more of the methods or functionalities as described herein.

Although the present specification describes components and functions that may be implemented in particular implementations with reference to particular standards and protocols, the disclosure is not limited to such standards and protocols. For example, standards for Internet and other packet switched network transmission (e.g., TCP/IP, UDP/IP, HTML, HTTP) represent examples of the state of the art. Such standards are periodically superseded by faster or more efficient equivalents having essentially the same functions. Accordingly, replacement standards and protocols having the same or similar functions as those disclosed herein are considered equivalents thereof.

It will be understood that the operations of methods discussed are performed in one embodiment by an appropriate processor (or processors) of a processing (i.e., computer) system executing instructions (computer-readable code) stored in storage. It will also be understood that the disclosure is not limited to any particular implementation or programming technique and that the disclosure may be implemented using any appropriate techniques for implementing the functionality described herein. The disclosure is not limited to any particular programming language or operating system.

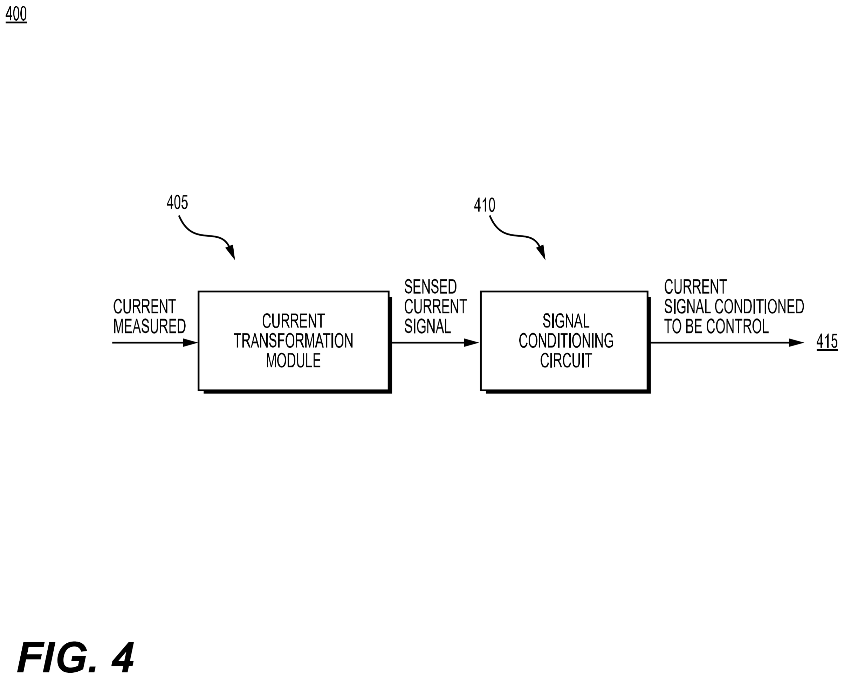

FIG. 4 depicts a block diagram of a current sensor 400 with a current transformation module and signal conditioner, according to one or more embodiments. As shown in FIG. 4, current sensor 400 may include a current transformation module 405 and a signal conditioner 410. Current transformation module 405 may receive a current measured signal and may convert the current measured signal to a sensed current signal. The sensed current signal may be transmitted from current transformation module 405 to signal conditioner 410. Signal conditioner 410 may process the sensed current signal and may generate an output 415. Output 415 may be a current signal conditioned for control, which may be used for monitoring and/or control purposes in a power conversion system.

Current transformation module 405 may sense magnetic flux generated by current flowing through a busbar and may convert the magnetic flux into a voltage signal. The voltage signal may serve as the sensed current signal that current transformation module 405 transmits to signal conditioner 410. Signal conditioner 410 may amplify and/or condition the voltage signal to produce output 415 in a suitable format and scale for use by a controller and/or other system components.

Current sensor 400 may provide contactless current sensing without requiring physical contact with and/or modification of a current-carrying busbar. Current transformation module 405 may implement contactless sensing by detecting magnetic flux generated around the current-carrying busbar without direct electrical connection to the busbar. This contactless sensing approach may differ from conventional current conversion elements that may require physical modification of the busbar, such as reshaping the busbar to create notches, holes, and/or S-shaped configurations to concentrate magnetic flux for sensing purposes.

The contactless architecture of current sensor 400 may eliminate thermal limitations associated with conventional current conversion elements. Conventional current conversion elements may generate heat due to power losses in reshaped busbar sections, which may create thermal challenges in high-power applications. Current sensor 400 may avoid these thermal issues by, for example, maintaining an original busbar geometry without modification.

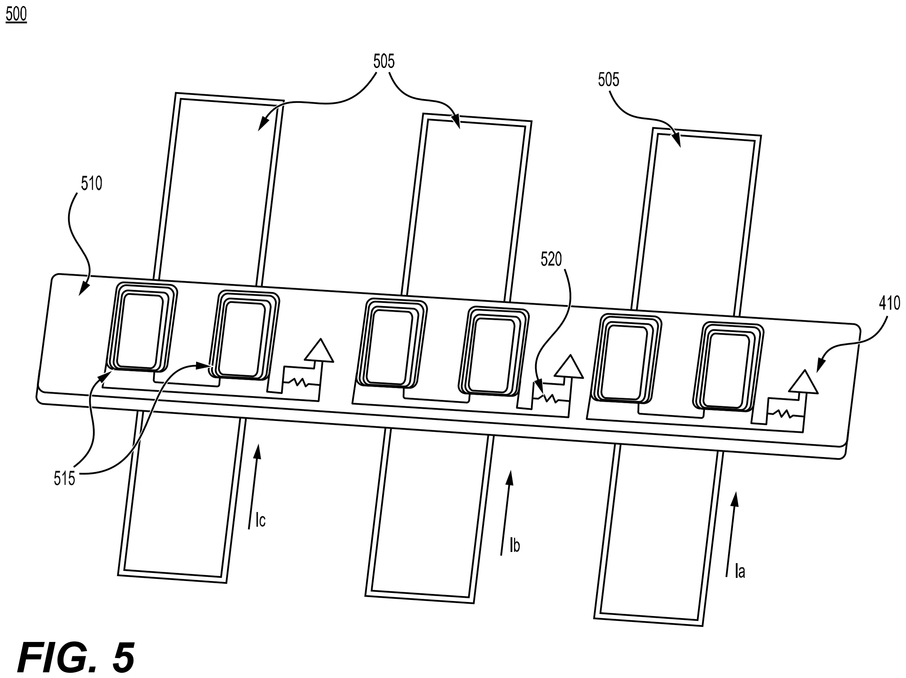

FIG. 5 depicts a perspective view of a current sensing system 500 with a busbar and PCB-integrated coils, according to one or more embodiments. As shown in FIG. 5, system 500 may include busbar 505, PCB 510, coils 515, resistors 520, and signal conditioner 410. Busbar 505 may be a conductive element configured to carry electrical current. In some cases, busbar 505 may be a direct current (DC) busbar configured to carry DC current in a power converter system. Busbar 505 may be an alternating current busbar (an AC busbar) configured to carry AC current in a power converter system.

PCB 510 may be positioned above busbar 505 and may include multiple coils 515 integrated within the structure of PCB 510. Coils 515 may be arranged in pairs on opposite sides of busbar 505, with each pair positioned to sense magnetic flux generated by current flowing through busbar 505. In the illustrated configuration, three pairs of coils 515 is shown, corresponding to three separate current sensing channels. Each pair of coils 515 may form a current sensor configured to sense current in busbar 505.

Each pair of coils 515 may be connected in series through resistors 520, which may be mounted on PCB 510. For example, a first coil 515 and a second coil 515 may be connected in a series electrical connection to form a current sensor. The series connection of coils 515 may generate a combined voltage output signal when magnetic flux passes through the coils 515. Resistors 520 may provide a connection between coils 515 and signal conditioner 410. In some cases, one or more of a resistor 520 or an inductor may be connected to signal conditioner 410 between signal conditioner 410 and coils 515.

Coils 515 may be made of copper traces integrated directly into the PCB substrate of PCB 510. The copper traces may form multiple turns within the layers of PCB 510 to create the coil structure. In some cases, coils 515 may be located in a first layer 511 of PCB 510. Additionally, PCB 510 may include a second layer 512, and additional coils 515 may be positioned in the second layer 512 of PCB 510. For example, a third coil 515 and a fourth coil 515 may be positioned in the second layer 512 of PCB 510 and may be connected to signal conditioner 410.

Signal conditioner 410 may receive voltage signals induced in coils 515 and may process these signals for further use. Signal conditioner 410 may be connected to the first coil 515 and the second coil 515 of each current sensor. In some cases, signal conditioner 410 may be positioned in the first layer 511 of PCB 510.

The arrangement of coils 515 on PCB 510 may allow for contactless current measurement without requiring modification to busbar 505. System 500 may eliminate the need for busbar reshaping, avoiding notches, holes, or S-shaped modifications required by traditional current sensors. Busbar 505 may not include a modification to concentrate magnetic flux for the current sensor formed by coils 515. Busbar 505 does not include a modification to concentrate magnetic flux for the current sensor formed by coils 515. The current sensor may not include a current converter in addition to the first coil 515 and the second coil 515.

With continued reference to FIG. 5, coils 515 may be arranged on an axis perpendicular to a direction of current flow in busbar 505. A center of a first coil 515 may be aligned with a first edge of busbar 505, and a center of a second coil 515 may be aligned with a second edge of busbar 505. System 500 may provide a compact configuration where the current sensing components are integrated into PCB 510, eliminating the need for separate current conversion elements.

In a three-phase system configuration, PCB 510 may include a second current sensor to sense a second current in a second DC busbar and a third current sensor to sense a third current in a third DC busbar. Each of the second current sensor and the third current sensor may include a first coil 515 in the first layer 511 of PCB 510 and a second coil 515 in the first layer 511 of PCB 510. PCB 510 may further include a second current signal conditioner connected to the first coil 515 of the second current sensor and the second coil 515 of the second current sensor, and a third current signal conditioner connected to the first coil 515 of the third current sensor and the second coil 515 of the third current sensor.

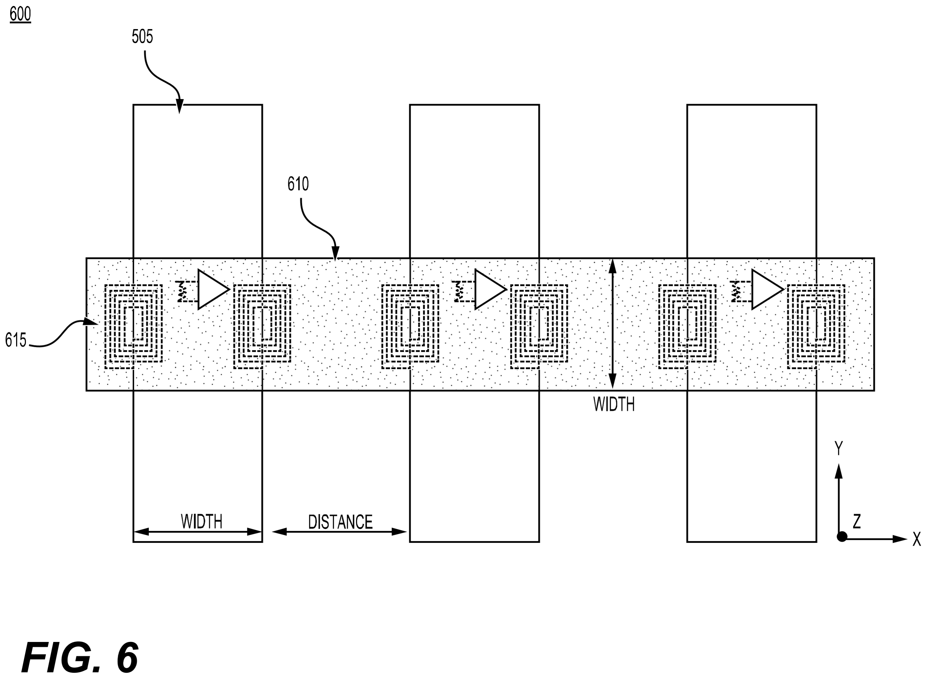

FIG. 6 depicts a top orthogonal view of the current sensing system 600 showing coil arrangement on the PCB, according to one or more embodiments. As depicted in FIG. 6, system 600 may include busbar 505 and a PCB 610 positioned above busbar 505. PCB 610 may include multiple coils 615 arranged in pairs along the width of busbar 505. The coils 615 may be embedded within PCB 610 and may be positioned to sense magnetic flux generated by current flowing through busbar 505.

Each pair of coils 615 may be symmetrically positioned on opposite sides of busbar 505, with the coils 615 aligned perpendicular to the direction of current flow in busbar 505. The symmetrical positioning of coils 615 may enable differential sensing of magnetic flux, where each coil 615 in a pair senses magnetic flux flowing in opposite directions around busbar 505. For example, a first coil 615 may sense magnetic flux emerging from one side of busbar 505, while a second coil 615 may sense magnetic flux entering the opposite side of busbar 505.

As shown in FIG. 6, system 600 may include three pairs of coils 615, each pair of coils 615 distributed along the width of each busbar 505, with spacing indicated between adjacent pairs. The scalable coil quantity aspect may allow for different numbers of coil pairs depending on the application requirements. For example, system 600 may include two coils 615 per phase for single-phase applications, or six coils 615 total for three-phase applications with two coils 615 per phase. The distance between the coils 615 and each busbar 505 may be approximately 0.5 mm. Each coil of coils 615 may include multiple turns.

The coils 615 may be depicted with concentric rectangular patterns representing multiple turns of conductive material within the layers of PCB 610. Each coil 615 may include a first coil in a first layer 511 of PCB 610 and may be connected to a second coil in the first layer 511 of PCB 610 in a series electrical connection. The first coil and the second coil may be arranged on an axis perpendicular to a direction of current flow in busbar 505. In some cases, a center of the first coil may be aligned with a first edge of busbar 505, and a center of the second coil may be aligned with a second edge of busbar 505.

PCB 610 may further include a current signal conditioner connected to the first coil and the second coil. The current signal conditioner may be configured to process voltage signals induced in the coils 615 and may generate conditioned output signals for use by a controller or other system components. In some cases, PCB 610 may include one or more of a resistor or an inductor connected to the current signal conditioner between the current signal conditioner and the first coil.

The current sensor formed by the coils 615 may be configured to sense current in busbar 505 without requiring modification to busbar 505 to concentrate magnetic flux. The current sensor may not include a current converter in addition to the first coil and the second coil, and busbar 505 may not include a modification to concentrate magnetic flux for the current sensor. This contactless current sensing configuration may eliminate the need for reshaping busbar 505 or creating notches, holes, or other modifications that could increase resistance and generate additional heat.

For three-phase applications, PCB 610 may further include a second current sensor to sense a second current in a second DC busbar and a third current sensor to sense a third current in a third DC busbar. Each of the second current sensor and the third current sensor may include a first coil in the first layer 511 of PCB 610 and a second coil in the first layer 511 of PCB 610. PCB 610 may further include a second current signal conditioner connected to the first coil of the second current sensor and the second coil of the second current sensor, and a third current signal conditioner connected to the first coil of the third current sensor and the second coil of the third current sensor. The first current signal conditioner, the second current signal conditioner, and the third current signal conditioner may be in the first layer 511 of PCB 610.

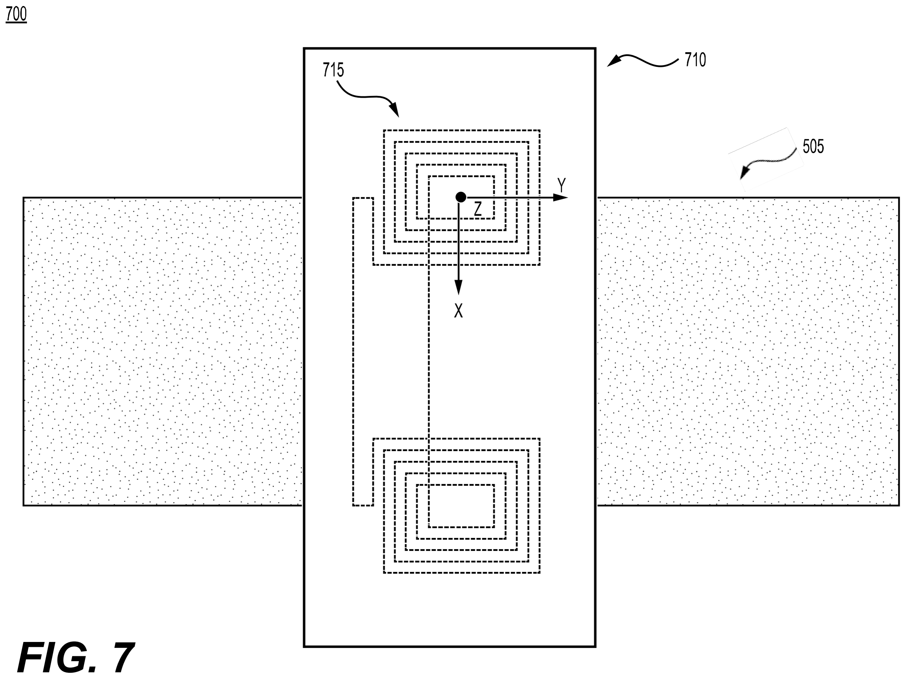

FIG. 7 depicts a top view of a current sensing system with two coils positioned relative to a busbar, according to one or more embodiments. As depicted in FIG. 7, system 700 may include busbar 505, PCB 710, and two coils 715. Coils 715 may be located on or within PCB 710. PCB 710 with coils 715 may be positioned adjacent to busbar 505. Busbar 505 is described above in the description of FIG. 5. Each coil of coils 715 may be depicted as a series of concentric rectangular loops, indicating multiple turns of conductive material. The coils 715 may be arranged symmetrically with respect to the busbar 505's longitudinal axis, with one coil of coils 715 located above busbar 505's longitudinal axis and another coil of coils 715 located below busbar 505's longitudinal axis in the view shown. The coils 715 may include multiple turns. The coils may include more than two coils.

The coils 715 may be configured to sense magnetic flux generated by current flowing through busbar 505. The arrangement may demonstrate a contactless current sensing configuration where the coils 715 do not require physical contact with busbar 505 or modification of the busbar structure. The first DC busbar may not include a modification to concentrate magnetic flux for the first current sensor. The positioning of the coils 715 on opposite sides of busbar 505 may enable differential sensing of the magnetic field produced by the current in busbar 505.

With continued reference to FIG. 7, the first coil of coils 715 and the second coil of coils 715 may be arranged on an axis perpendicular to a direction of the first current in the first DC busbar. The distance between the coils 715 and busbar 505 may be adjusted and calculated based on the desired sensitivity and output voltage requirements. A center of the first coil of coils 715 may be aligned with a first edge of busbar 505, and a center of the second coil of coils 715 may be aligned with a second edge of busbar 505. The system 700 may provide contactless current measurement capabilities without requiring reshaping or modification of the busbar geometry.

The first current sensor may not include a current converter in addition to the first coil of coils 715 and the second coil of coils 715. The coils 715 may function as the primary current conversion elements, eliminating the need for additional current transformation components such as current transformers, Hall effect sensors, or integrated current sensor ICs. The system 700 may achieve current sensing through the magnetic coupling between the current-carrying busbar and the coils 715, where the magnetic flux linkage changes with the AC current flowing through busbar 505.

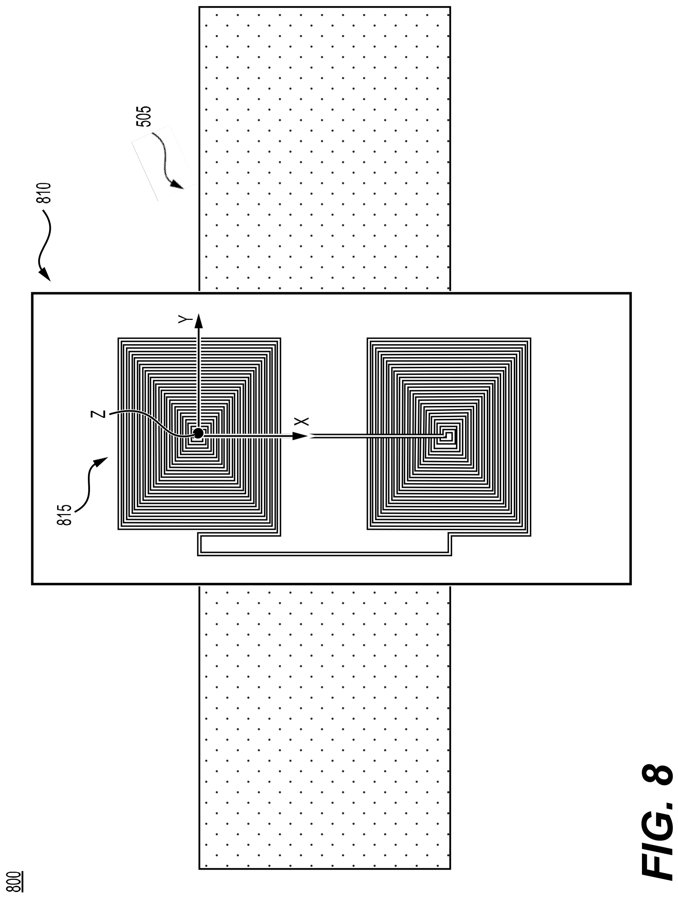

FIG. 8 depicts a top view of a current sensing system 800 with coils arranged symmetrically relative to a busbar, according to one or more embodiments. As depicted in FIG. 8, system 800 may include a busbar 505, PCB 810, and two coils 815 positioned within PCB 810 and on opposite sides of busbar 505. Busbar 505 is described above in the description of FIG. 5. Each coil of coils 815 may be depicted as a square spiral pattern with concentric rectangular turns, indicating a planar coil structure that may be integrated into PCB 810. The coils may include multiple turns. FIG 8 depicts coils including more turns than the coils of FIG. 7.

The coils 815 may be symmetrically positioned relative to busbar 505, with the centers of the coils 815 aligned along an axis perpendicular to the longitudinal direction of busbar 505. In some cases, a center of a first coil of coils 815 may be aligned with a first edge of busbar 505, and a center of a second coil of coils 815 may be aligned with a second edge of busbar 505. This edge alignment configuration may enable precise positioning of the coils 815 for contactless current measurement.

The coils 815 may be configured to sense magnetic flux generated by current flowing through busbar 505. The symmetrical arrangement of the coils 815 may provide differential sensing capabilities, where each coil of coils 815 detects magnetic field variations on opposite sides of busbar 505. This configuration may enable contactless current measurement without requiring modification to the busbar structure.

With continued reference to FIG. 8, the system 800 may utilize the edge-aligned positioning of the coils 815 to optimize magnetic flux coupling. The first coil of coils 815 and the second coil of coils 815 may be arranged on an axis perpendicular to a direction of current flow in busbar 505. This perpendicular arrangement may enhance the sensitivity of the current sensing system by positioning the coils 815 where magnetic field strength may be increased relative to the current-carrying conductor.

The current sensing operation may be governed by several mathematical relationships that define the conversion of current flow to measurable voltage signals. A magnetic flux density B may be generated around a busbar when current flows through the busbar, and the magnetic flux density B may be calculated using the equation: $B = \frac{μI}{2 πd}$ where µ represents the permeability of the medium, I represents the measured current flowing through the busbar, and d represents the distance from the busbar to a coil. The permeability µ may vary depending on the material properties of the medium surrounding the busbar and coil arrangement.

The magnetic flux Φ may be determined by integrating the magnetic flux density B over the area enclosed by a coil. The flux calculation may be expressed as: $Φ = ∮ Bds$ where the integral ∲ *Bds* represents the integration of the magnetic flux density B over the surface area enclosed by the coil. The magnetic flux Φ may change with time as the alternating current varies, creating a time-varying magnetic field.

A voltage sensing signal Vsen may be induced in a coil due to the time-varying magnetic flux, and the voltage sensing signal Vsen may be calculated using Faraday's law of electromagnetic induction for a coil: ${V}_{sen} = N \frac{dΦ}{dt}$ where N represents the number of turns of the coil and $\frac{dΦ}{dt}$ represents the rate of change of magnetic flux with respect to time. The number of turns N may directly influence the magnitude of the induced voltage sensing signal Vsen.

A conditioned output voltage Vo may be generated by processing the voltage sensing signal Vsen through a signal conditioning circuit. The conditioned output voltage Vo may be calculated using the equation: ${V}_{o} = G \times {V}_{sen}$ where G represents the gain of the current signal conditioning circuit. The gain G may be selected to amplify the voltage sensing signal Vsen to a suitable level for use by a microcontroller or other control circuitry.

The mathematical relationships may relate to coil parameter design by establishing the relationship between the number of turns N and the resulting voltage sensing signal Vsen. A coil may be implemented with different numbers of turns to achieve desired sensing characteristics. For example, a coil may include 10 turns, 15 turns, or 20 turns, depending on the current range and desired output voltage requirements. The number of turns N may be selected based on the expected current range I and the required voltage sensing signal Vsen magnitude. A higher number of turns N may produce a larger voltage sensing signal Vsen for a given rate of change of magnetic flux, while a lower number of turns N may produce a smaller voltage sensing signal Vsen.

The distance d between the busbar and coil may also influence the magnetic flux density B and subsequently affect the voltage sensing signal Vsen. The coil parameter design process may involve iterative calculations using these mathematical relationships to determine optimal values for the number of turns N, coil positioning, and signal conditioning circuit gain G to achieve the desired current sensing performance.

A PCB may be configured as a single layer PCB or as a multi-layer PCB to accommodate different coil arrangements and voltage output requirements. In some cases, a single layer PCB may include coils positioned on one layer of the PCB structure. Alternatively, a multi-layer PCB may include coils distributed across multiple layers, such as a top layer and a bottom layer of the PCB.

In a multi-layer PCB configuration, a first layer of the PCB may include a first coil and a second coil positioned to sense magnetic flux from a busbar. A second layer of the PCB may include a third coil and a fourth coil, where the third coil and the fourth coil may be positioned to provide additional magnetic flux sensing capability. The third coil and the fourth coil may be connected to a signal conditioner, along with the first coil and the second coil, to provide combined voltage output signals.

The multi-layer arrangement may provide flexibility in coil quantity and positioning to achieve desired voltage output levels. For example, when two coils on a single layer do not generate sufficient output voltage for a particular application, additional coils may be added on a second layer to increase the total voltage output. The number of coils may be adjusted based on the current measurement range and the required sensitivity of the current sensor system.

A signal conditioner may include amplification circuitry configured to process voltage signals from multiple coils across different PCB layers. The amplification circuitry may include adjustable gain components to condition the coil output voltage to a specific voltage level. In some cases, the signal conditioner may condition the coil output voltage to approximately 5V for microcontroller compatibility. The 5V output level may provide a suitable voltage range for analog-to-digital conversion and processing by microcontroller circuits commonly used in power conversion systems.

The multi-layer PCB configuration may allow for increased coil density without expanding the overall footprint of the current sensor system. The distribution of coils across multiple layers may provide enhanced magnetic flux coupling while maintaining a compact PCB design. The signal conditioner may be configured to combine and process voltage signals from coils on different layers to produce a single conditioned output signal representative of the measured current.

A printed circuit board (PCB) may be configured for three-phase current sensing applications. The PCB may include a first layer and may be designed to accommodate multiple current sensors for sensing currents in different phases of a three-phase electrical system.

The PCB may include a first current sensor to sense a first current, a second current sensor to sense a second current, and a third current sensor to sense a third current. Each of the first current sensor, the second current sensor, and the third current sensor may include a first coil in the first layer of the PCB and a second coil in the first layer of the PCB. The first coil and the second coil of each current sensor may be positioned to sense magnetic flux generated by current flowing through respective busbars or conductors.

In some cases, the PCB may further include a second layer. Each of the first current sensor, the second current sensor, and the third current sensor may further include a third coil in the second layer of the PCB and a fourth coil in the second layer of the PCB. The additional coils in the second layer may provide enhanced sensitivity and may increase the voltage output of each current sensor. When the first coil and the second coil are located on the first layer of the PCB and the third coil and the fourth coil are located on the second layer of the PCB, the third coil and the fourth coil may be aligned with the first coil and the second coil respectively to increase magnetic flux coupling.

The PCB may further include a first current signal conditioner connected to the first current sensor, a second current signal conditioner connected to the second current sensor, and a third current signal conditioner connected to the third current sensor. The first current signal conditioner may receive voltage signals from the first coil and the second coil of the first current sensor. The second current signal conditioner may receive voltage signals from the first coil and the second coil of the second current sensor. The third current signal conditioner may receive voltage signals from the first coil and the second coil of the third current sensor.

The first current signal conditioner, the second current signal conditioner, and the third current signal conditioner may be positioned in the first layer of the PCB or the second layer of the PCB. The signal conditioners may include amplification circuits, filtering circuits, and/or conditioning circuits to process the voltage signals received from the respective current sensors. Each signal conditioner may amplify the voltage signals to suitable levels for further processing by control circuits or microcontrollers.

The coils of each current sensor may be arranged symmetrically on opposite sides of respective current-carrying conductors. The first coil and the second coil of each current sensor may be connected in series to generate a differential voltage signal proportional to the current flowing through the respective conductor. The coils may be formed as conductive traces within the layers of the PCB, eliminating the need for separate current conversion elements.

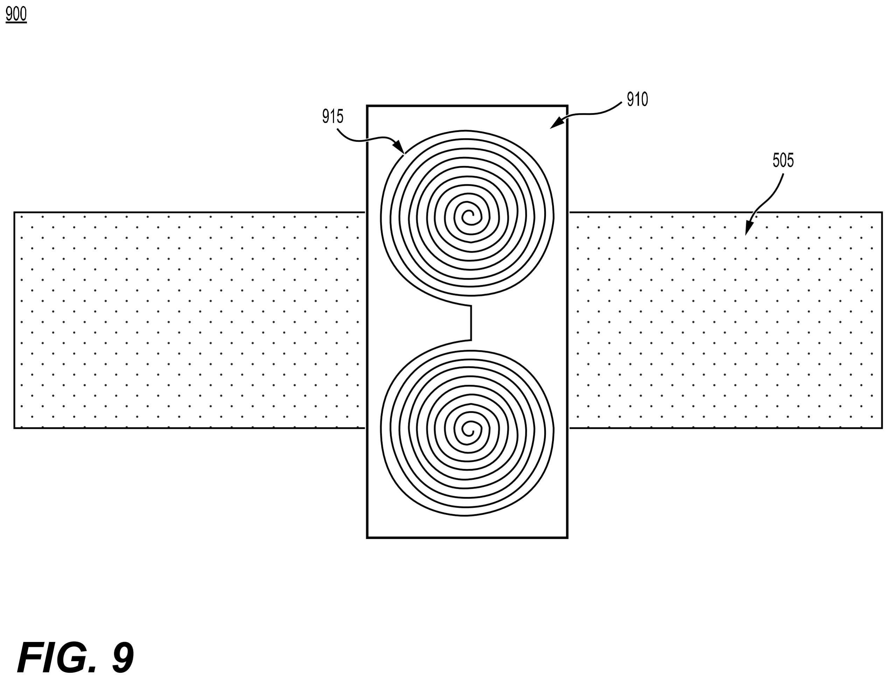

FIG. 9 depicts a top view of a current sensing system 900 with circular coils arranged symmetrically relative to a busbar, according to one or more embodiments. As depicted in FIG. 9, system 900 may include busbar 505, PCB 910, and two coils 915 arranged symmetrically within PCB 910 and relative to busbar 505. Busbar 505 is described above in the description of FIG. 5. Further, FIG. 9 illustrates an embodiment substantially similar to that of FIG. 8, such that the description of FIG. 8 applies equally to FIG. 9, except that coils 915 are arranged in a circular configuration instead of the rectangular configuration of FIG. 8.

For example, each coil of coils 915 may be depicted as a circular spiral pattern with concentric circular turns, indicating a planar coil structure that may be integrated into PCB 910. The coils may include multiple turns. The coils 915 may be symmetrically positioned relative to busbar 505, with the centers of the coils 915 aligned along an axis perpendicular to the longitudinal direction of busbar 505. In some cases, a center of a first coil of coils 915 may be aligned with a first edge of busbar 505, and a center of a second coil of coils 915 may be aligned with a second edge of busbar 505. This edge alignment configuration may enable precise positioning of the coils 815 for contactless current measurement.

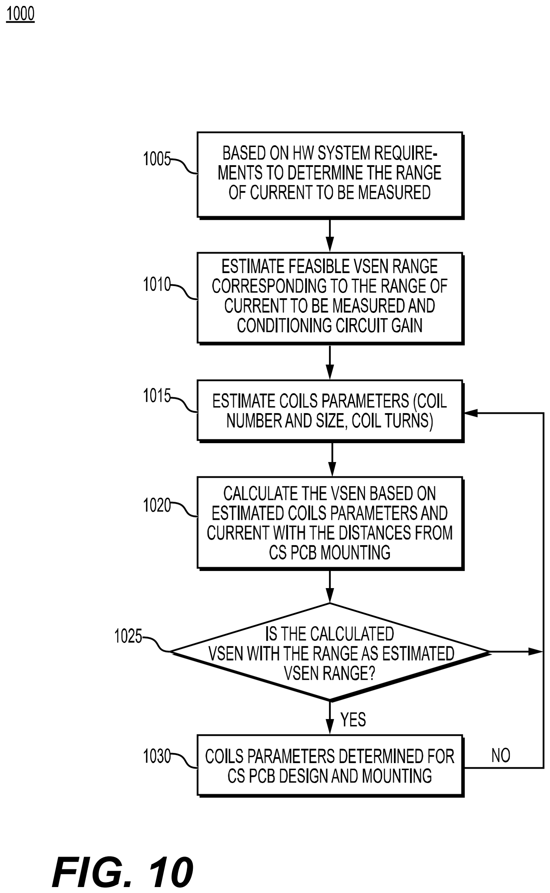

FIG. 10 depicts a flowchart for a method 1000 for determining coil parameters for a current sensor, according to one or more embodiments. As depicted in FIG. 10, method 1000 may provide an iterative design process for determining coil parameters based on target current range and output voltage specifications. Method 1000 may begin with operation 1005, where a range of current to be measured may be determined based on hardware system requirements. Operation 1005 may establish the fundamental parameters for the current sensing system by defining the minimum and maximum current values that the sensor may need to detect and measure accurately.

Method 1000 may then proceed to operation 1100, where a feasible voltage sense range may be estimated corresponding to the range of current to be measured and conditioning circuit gain. Operation 1100 may determine the target output voltage range that the coils may need to generate to provide adequate signal levels for the signal conditioning circuit. The voltage sense range may be selected to ensure compatibility with downstream processing components and to provide sufficient signal-to-noise ratio for accurate current measurement.

With continued reference to FIG. 10, method 1000 may then move to operation 1015, where coil parameters may be estimated, including coil number and size, and coil turns. Operation 1015 may involve determining the physical characteristics of the coils, such as the number of turns in each coil, the dimensions of each coil, and the total number of coils to be used in the current sensing system. The coil parameters may be initially estimated based on the current range determined in operation 1005 and the voltage sense range estimated in operation 1010.

Method 1000 may then advance to operation 1200, where the voltage sense may be calculated based on the estimated coil parameters and current with the distances from current sensor PCB mounting. Operation 1200 may use electromagnetic field calculations to determine the actual voltage that may be induced in the coils based on the magnetic flux generated by the current flowing through the busbar (e.g., busbar 505). The calculation may take into account the distance between the coils and the busbar, as well as the specific geometry and positioning of the coils relative to the current-carrying conductor.

As further shown in FIG. 10, method 1000 may then proceed to operation 1025, which may involve a decision point to determine whether the calculated voltage sense is within the range as the estimated voltage sense range. Operation 1025 may compare the calculated voltage from operation 1020 with the target voltage range established in operation 1010. If the calculated voltage sense is within the estimated voltage sense range, method 1000 may proceed to operation 1030. If the calculated voltage sense is not within the estimated voltage sense range, method 1000 may return to operation 1015 to re-estimate the coil parameters.

Method 1000 may then proceed to operation 1030, where the coil parameters may be determined for current sensor PCB design and mounting. Operation 1030 may finalize the coil specifications, including the number of turns, coil dimensions, and positioning requirements for integration into the PCB. The finalized parameters may ensure that the current sensing system meets the performance requirements established in the earlier operations of method 1000.

The iterative design process of method 1000 may adjust coil parameters until the calculated voltage falls within the desired range, thereby ensuring proper current sensing functionality. The coil parameters, including number of turns, size, and position, may be determined through this iterative design process based on target current range and output voltage specifications. For example, the first coil and the second coil may be arranged on an axis perpendicular to a direction of the first current in the first DC busbar to optimize magnetic flux sensing. In some cases, a center of the first coil may be aligned with a first edge of the first DC busbar, and a center of the second coil may be aligned with a second edge of the first DC busbar to provide symmetrical sensing of the magnetic field generated by the current flow.

One or more embodiments may eliminate the need for current conversion elements such as current transformers, Hall effect sensors, or integrated current sensor ICs by integrating coils directly into a printed circuit board positioned above a busbar. One or more embodiments may achieve accurate current measurement without requiring busbar modifications such as notches, holes, or S-shaped configurations that are typically needed for conventional current sensors. One or more embodiments may eliminate thermal problems associated with reduced cross-sectional areas in reshaped busbars, which can cause increased power losses and elevated temperatures in high-power applications. One or more embodiments may provide PCB-integrated coils that are inherently more robust than discrete current conversion elements and less sensitive to vibration and displacement in X, Y, or Z directions, thereby improving measurement accuracy and system reliability.

One or more embodiments may provide substantial cost advantages by eliminating the need for separate current conversion elements and their associated auxiliary components such as power supplies and additional PCBs. One or more embodiments may enable more compact packaging designs by removing the space requirements for large current transformers or discrete sensor components, thereby reducing overall system size and simplifying thermal management requirements. One or more embodiments may improve system reliability by removing potential failure points associated with discrete current conversion elements and eliminating busbar reshaping requirements that can compromise mechanical integrity of current-carrying conductors.

One or more embodiments may provide contactless sensing that offers galvanic isolation between the current path and the measurement circuit, enhancing safety and reducing electromagnetic interference. One or more embodiments may provide flexibility in implementation by allowing multiple coils to be integrated into different layers of a multi-layer PCB, enabling increased sensitivity or redundancy as required by specific applications ranging from low-power to high-power current sensing in electric vehicle power conversion systems.

Other embodiments of the disclosure will be apparent to those skilled in the art from consideration of the specification and practice of the invention disclosed herein. It is intended that the specification and examples be considered as exemplary only, with a true scope of the invention being indicated by the following claims.

## Claims

1. A system comprising a power converter, the power converter including:
a first alternating current (AC) busbar; and
a printed circuit board (PCB), the PCB including a first current sensor to sense a first current in the first AC busbar,
wherein the first current sensor includes:
a first coil in a first layer of the PCB,
a second coil in the first layer of the PCB, the second coil connected to the first coil in a series electrical connection, and
a first current signal conditioner connected to the first coil and the second coil.

2. The system of claim 1, wherein the first current sensor does not include a current converter in addition to the first coil and the second coil.

3. The system of any one of claims 1 to 2, wherein the first AC busbar does not include a modification to concentrate magnetic flux for the first current sensor.

4. The system of any one of claims 1 to 3, wherein the first current sensor further includes:
a third coil in a second layer of the PCB, and
a fourth coil in the second layer of the PCB,
wherein the third coil and the fourth coil are connected to the first current signal conditioner.

5. The system of any one of claims 1 to 4, the power converter further including:
a second AC busbar; and
a third AC busbar.

6. The system of claim 5, the PCB further including:
a second current sensor to sense a second current in the second AC busbar; and
a third current sensor to sense a third current in the third AC busbar,
wherein each of the second current sensor and the third current sensor includes a first coil in the first layer of the PCB and a second coil in the first layer of the PCB;
and the PCB, preferably, further including:
a second current signal conditioner connected to the first coil of the second current sensor and the second coil of the second current sensor; and
a third current signal conditioner connected to the first coil of the third current sensor and the second coil of the third current sensor.

7. The system of any one of claims 1 to 6, wherein the first coil and the second coil are arranged on an axis perpendicular to a direction of the first current in the first AC busbar;
and wherein, preferably a center of the first coil is aligned with a first edge of the first AC busbar, and a center of the second coil is aligned with a second edge of the first AC busbar.

8. The system of any one of claims 1 to 7, further comprising:
one or more controllers configured to control the power converter based on the first current.

9. The system of any one of claims 1 to 8, further comprising:
a battery; and
a motor connected to one or more of the battery or the power converter,
wherein the battery, the motor, and the power converter are provided as a vehicle.

10. A current sensor comprising:
a first coil in a first layer of a printed circuit board (PCB); and
a second coil in the first layer of the PCB,
wherein the current sensor is configured to sense a current.

11. The current sensor of claim 10, further comprising:
a current signal conditioner connected to the first coil and the second coil.

12. The current sensor of claim 11, further comprising one or more of a resistor or an inductor connected to the current signal conditioner between the current signal conditioner and the first coil;
and/or further comprising:
a third coil in a second layer of the PCB; and
a fourth coil in the second layer of the PCB,
wherein the third coil and the fourth coil are connected to the current signal conditioner.

13. The current sensor of any one of claims 10 to 12, wherein the current sensor is configured to sense the current in a busbar.

14. A printed circuit board (PCB) comprising:
a first layer;
a first current sensor to sense a first current;
a second current sensor to sense a second current; and
a third current sensor to sense a third current,
wherein each of the first current sensor, the second current sensor, and the third current sensor includes a first coil in the first layer of the PCB and a second coil in the first layer of the PCB;
and, preferably, further comprising:
a second layer,
wherein each of the first current sensor, the second current sensor, and the third current sensor further includes a third coil in the second layer of the PCB and a fourth coil in the second layer of the PCB.

15. The PCB of claim 14, further comprising:
a first current signal conditioner connected to the first current sensor;
a second current signal conditioner connected to the second current sensor; and
a third current signal conditioner connected to the third current sensor.
and wherein, preferably, the first current signal conditioner, the second current signal conditioner, and the third current signal conditioner are in the first layer of the PCB.
